Europäisches Patentamt

European Patent Office

Office européen des brevets

(19)

(11) Publication number: **0 370 311 B1**

# EUROPEAN PATENT SPECIFICATION

(45) Date of publication of patent specification: **17.08.94**   (51) Int. Cl.5: **C23C 16/44**, C23C 16/52, C30B 25/14

(21) Application number: **89120715.1**

(22) Date of filing: **08.11.89**

(54) **Chemical vapor deposition system and reactant delivery section therefor.**

(30) Priority: **23.11.88 US 276254**

(43) Date of publication of application:
**30.05.90 Bulletin 90/22**

(45) Publication of the grant of the patent:
**17.08.94 Bulletin 94/33**

(84) Designated Contracting States:
**DE FR GB IT NL**

(56) References cited:
**EP-A- 0 311 446**
**US-A- 4 341 107**

(73) Proprietor: **APPLIED MATERIALS, INC.**
**P.O. Box 58039**
**3050 Bowers Avenue**
**Santa Clara California 95052-8039 (US)**

(72) Inventor: **Collins, Kenneth Stuart**
**260 West Dunne Ave**
**23, Morgan Mill CA (US)**
Inventor: **Ishikawa, Tetsuya**
**208 Kosaku Cho Funabashi**
**City Chiba (JP)**
Inventor: **Toshima, Masato**
**1614 Swallow Drive**
**Sunnyvale California 94087 (US)**
Inventor: **Cheng, David**
**974 Sherman Oaks Drive**
**San Jose CA95128 (US)**

(74) Representative: **DIEHL GLAESER HILTL &**
**PARTNER**
**Patentanwälte**
**Postfach 19 03 65**
**D-80603 München (DE)**

## Description

The present invention relates to semiconductor processing and, more specifically, to a chemical vapor deposition system and a reactant delivery section.

Integrated circuits are pervasive and essential components of a wide variety of goods and tools. Not only are they the basis of modern computers, and other high-technology fare, but integrated circuits are commonplace in cameras, kitchen appliances, toys, musical instruments, etc. Integrated circuits typically include a number of layers formed on a substrate, which is most commonly of crystalline silicon. Different processes are used to form the various layers. One of the more important processes, chemical vapor deposition, is used to deposit epitaxial silicon, polycrystalline silicon, doped and undoped silicon dioxide and silicon nitride, as well as other materials.

Chemical vapor deposition is the formation of a layer on a substrate by thermal reaction or decomposition of gaseous compounds. Systems for accomplishing chemical vapor deposition include horizontal systems, vertical systems, cylindrical systems, and gas-blanketed downflow systems These systems have certain elements in common, e.g., a reaction chamber, a gas delivery section, a time and sequence controller, a heat source for the deposition reaction, and an effluent handling section. The reaction chamber contains and defines a controlled environment about the wafer being processed. The gas delivery section controls the amount of gas that flows into the reaction chamber. The time and sequence controller, which can be either manual or automated, coordinates the timing of the other components. The heat source, which can be selected to provide cold-wall heating or hot-wall heating , is used to heat the substrate as well as help control gas temperature. The effluent handling section exhausts all unreacted gas. properly deactivating any harmful gases. In some systems, the effluent handling system exhausts gases at a rate which is varied to maintain a constant chamber pressure.

One of the challenges in designing a chemical vapor deposition system is to provide a sufficient and precisely controlled flow of reactant gas. Typically, a liquid source is used to provide the vapor constituting the reactant gas. The most common approach to liquid source delivery involves the use of a boiler or bubbler. The mass flow rate of vapor from the liquid source depends on the pressure difference between the pressure at the source and the pressure of the reaction chamber. Since many liquid sources have relatively low vapor pressures, the mass flow rate is limited to low values, except at high liquid temperatures and low chamber pressures. A notable example of a liquid source with relatively low vapor pressure is tetraethylorthosilicate (TEOS) which is used as a silicon source for silicon dioxide deposition.

In systems using a boiler to generate reactant gas, the liquid source temperature is raised to a high enough level to yield a vapor pressure much greater than the pressure in the chamber to which reactant is delivered. A mass flow controller (MFC) is located between the liquid source boiler and the chamber. While this type of system is conceptually simple, reliability is a problem. All components downstream of the boiler must be maintained at a higher temperature than the liquid to avoid condensation. Ensuring the reliability of these components, especially electro-mechanical components such as the MFC and other valves, at high temperatures is difficult. Furthermore, operation of a boiler system in conjunction with higher chamber pressures is problematic due to the requirement of some minimum pressure drop across the MFC.

A proposed alternative is to inject liquid source as a mist which is then vaporized by a heating element. The vaporized reactant could then diffuse or be swept by a carrier gas stream to a reaction chamber. In theory, the flow rate of reactant gas would be known from the amount of liquid source injected. In practice, this approach has not realized the precision required for many chemical vapor deposition processes.

Reactant gas flow can be increased greatly by introducing a carrier gas, such as helium or another chemically inert gas, through the liquid. The first order equation describing the mass transport rate of reagent gas ($Q_r$), assuming saturation of the carrier with reactant gas, is:

$$Q_r = \frac{k\, P_v\, Q_c}{P_g - P_v}$$

where k is a constant, $P_v$ is the vapor pressure of the liquid at a particular temperature, $P_g$ is the total pressure of the gas mixture above the liquid, and $Q_c$ is the mass flow rate of the carrier gas.

There are several problems with using a carrier to transport reactant gas. $P_v$ is an exponential function of liquid temperature. This means that $P_v$ must be very tightly controlled, especially at elevated temperatures. The assumption of saturation may not be valid, especially as the liquid level is reduced. The pressure of the gas mixture $P_g$ is a function of $P_v$, carrier flow rate, downstream gas line conductance, and downstream chamber pressure. Thus, the mass flow rate of the reactant vapor is easily perturbed by many difficult-to-control variables.

If more control over gas flow is accomplished by maintaining low temperatures throughout, then a lower reactant gas mass flow results and a lower gas pressure in the chamber is required so that a pressure drop is established across the mass flow controller. However, low flow rates and low chamber pressures are non-optimal conditions for many deposition reactions. What is needed that has not been heretofore provided is a chemical vapor deposition system which provides for large and precisely controlled reactant gas flows even with relatively high reaction chamber pressures. A major objective of the present invention is, therefore, to provide a chemical vapor deposition system with precisely controllable delivery of a reactant gas into a reaction chamber.

This object is solved by the chemical vapor deposition system of independent claim 1 and the reactant delivery system of independent claim 2. Further advantageous features of these systems are evident from the dependent claims.

In accordance with the present invention, a chemical vapor deposition system relies on the concerted action of two closed loops, one associated with a gas delivery section and the other preferably associated with an effluent handling section. The gas delivery loop uses the difference between a combined flow sensor and a carrier-only flow sensor to determine reactant gas flow, which is regulated accordingly. The effluent handling loop regulates the pressure in a reaction chamber by adjusting the rate gases are removed from the chamber. Maintaining a constant pressure in the chamber to which the gas delivery section transports reactant ensures that the gas delivery loop can converge to a stable condition.

The chemical vapor deposition system comprises the gas delivery section, the reaction chamber, the effluent handling section, a heat source for heating wafers within the reaction chamber, and a system controller for coordinating the previously listed components. The gas handling section includes a carrier source, a carrier flow valve, a carrier mass flow sensor, a liquid source of gaseous reactant, and a reactant mass flow sensor. The reactant flow sensor measures the combined flow of the carrier and reactant gases. The contribution of the carrier gas to the combined flow is indicated by the carrier flow sensor. The difference is the actual reactant flow rate which the controller compares to a target reactant flow rate, adjusting carrier flow valve accordingly. Since reactant gas flow correlates with carrier gas flow, the former is effectively regulated.

Calibration can be effected in two steps, one involving relative calibration of the mass flow sensors, and the other involving absolute calibration of one or both of the sensors. Relative calibration is accomplished by closing valves to and from the liquid source and opening a valve permitting the carrier-only gas to pass through both sensors. By taking measurements at a number of different carrier flow rates from both sensors, one can derive a transformation which permits readings from the carrier flow sensor to be translated into the readings the reactant flow sensor would have had for the same flow rate. This transformation is used during deposition so that the combined flow rate can be validly compared with the carrier-only flow rate. The reactant flow sensor, or both sensors, can then be calibrated against a known mass flow, for example, using a conventional "leak-up" test. The calibration results can be implemented in software and applied by the system controller during deposition procedures.

Several features of the preferred embodiments of the present invention address concerns as to the sensitivity and stability of the gas delivery loop. As indicated, the effluent handling loop maintains constant chamber pressure which contributes stability to the gas delivery loop. The use of helium as the carrier gas provides a relatively large volume of carrier gas for greater reactant carrying capacity in conjunction with a low contribution of carrier mass to the combined flow detected by the reactant mass flow sensor. The favorable reactant-to-carrier ratio permits a sensitive determination of reactant flow, which can thus be precisely regulated. Since the gas delivery loop does not rely directly on temperatures and pressures, greater ranges and deviations from nominal conditions are tolerated. This in turn increases the selection of processes and conditions available for deposition reactions. These and other features and advantages of the present invention are apparent from the description below with reference to the following drawings.

FIGURE 1 is a schematic illustration of a chemical vapor deposition system in accordance with the present invention.

FIGURE 2 is a flow diagram of a control loop used by the chemical vapor deposition system of FIG. 1 to regulate gas delivery.

A chemical vapor deposition (CVD) system 100 comprises a reaction chamber 102 in which deposition reactions occur, a gas delivery section 104 for delivering reactant gas used in the deposition reaction, a heat source 106 for providing heat to facilitate the deposition reaction, an effluent handling section 108 for disposing of spent gases from the deposition reaction, and a system controller 110 for coordinating the operation of the recited components. CVD system 100 provides for deposition of a selected material on a wafer 99, situated on a wafer holder 112 within reaction chamber 102. To ensure ample reactant gas is available for the deposition reaction, gas delivery section 104 provides a carrier gas to sweep reactant gas into reaction chamber 102.

Introduction of reactant gas into reaction chamber 102 is precisely controlled using tandem control loops, a gas delivery loop and an effluent handling loop. The gas delivery loop utilizes a mass flow sensor, i.e., reactant flow sensor 114, to detect reactant gas being transported into reaction chamber 102. Since the reading provided by reactant flow sensor 114 reflect carrier gas as well as reactant gas, a second mass flow sensor, i.e., carrier flow sensor 116, is used to measure carrier gas flow prior to mixing with reactant gas. Controller 110 determines reactant gas flow by comparing readings from reactant flow sensor 114 and carrier flow sensor 116. This comparison provides a basis for adjusting a variable carrier flow valve 118 which controls carrier flow rate, which in turn regulates the reactant flow rate. The effluent handling loop uses data from a pressure sensor 120, arranged to detect the pressure in reaction chamber 102 to control the pumping rate of a variable delivery exhaust pump 122, of effluent handling section 108. Maintenance of a constant pressure in reaction chamber 102 ensures a stable operating point for the gas delivery loop.

CVD system 100 defines a gas stream which extends from a carrier source 124 of gas delivery section 104 through effluent handling section 108. Carrier source 124 provides a flow of carrier gas to serve as the carrier gas and includes a pressure regulator to maintain a constant flow pressure, e.g., about 0.207 bar (about 2 psi). The carrier gas is pre-heated to a temperature greater than that of liquid source 136 to minimize convective cooling, which would disturb the thermal equilibrium of the liquid source, and to partially compensate for heat loss due to vaporization of the liquid reactant.

Helium is the preferred carrier gas because it is relatively inert and because of its low atomic mass. Inertness minimizes interference with the CVD reaction and minimizes problems with contamination. Low atomic mass results in a low mass flow to volume flow ratio. Since, for a given carrier pressure, reactant flow correlates with carrier volume flow, the use of a carrier with low atomic mass results in a relatively high reactant-to-carrier mass flow ratio. This translates into a favorable signal-to-noise ratio in the mass flow readings from reactant flow sensor 114, where the "signal" is the reactant's contribution to these readings and the "noise" is the carrier's contribution to these readings. The high signal-to-noise ratio results in a more precise determination, and corresponding more precise control, of reactant flow.

Carrier and reactant gases are transported between system components along conventional tubing 126. Helium from carrier source 124 flows through carrier flow valve 118, which is a throttle valve controlled by system controller 110. Since carrier flow affects reactant flow, carrier control valve 118 effects adjustments in reactant flow to maintain a level called for by a given process recipe. Helium passing through carrier valve 118 is detected by carrier flow sensor 114, which provides a measurement of the helium mass flow rate. Conveniently, the illustrated carrier flow sensor 116 and carrier flow valve 118 are components of a commercially available mass flow controller.

During deposition, a calibration valve 128 is closed while an ampule inlet valve 130 and an ampule outlet valve 132 are open. Helium is accordingly directed through ampule inlet valve 130 and into an ampule 134.

Ampule 134 is a vacuum tight enclosure which contains a liquid source 136 for the reactant gas. In the present case, the reactant gas is tetraethylorthosilicate (TEOS), a source of silicon used in deposited layers of silicon dioxide. Of course, other reactants can be used for depositing other materials or for depositing silicon dioxide according to another recipe. A diffuser wick 138 with multiple small apertures 140 is used to diffuse the helium into liquid source 136 to increase the surface area to volume ratio of the helium bubbles 142 formed. This increased ratio enhances the saturation of helium by TEOS. Bubbles 144 of a helium/TEOS mix move through liquid source 136, whence the combined gas can be transported out of ampule 134 to reaction chamber 102.

A level sensor 146 is used so that controller 110 can monitor liquid source level in ampule 134 to determine when replenishment is required. The temperature of liquid source 136 is monitored using a thermal sensor 148, the readings of which are used by controller 110 in regulating a heater element 150 embedded in ampule 134. Ampule 134 includes an thermally insulating wall 152 to minimize thermal gradient across liquid source 136.

The combined gas, i.e., the helium/TEOS mixture, flows out of ampule 134 and through a mist separator 154 which is provided to prevent liquid from moving toward reaction chamber 102. Mist separator 154 includes a fine, e.g., 0.01 to 0.1 $\mu$m, filter 155 which is heated to vaporize impinging liquid droplets. Droplets not vaporized drip back into ampule 134.

The combined gas flows through ampule outlet valve 132 and through reactant flow sensor 114. Reactant flow sensor 114 can be obtained by removing the valve from a mass flow controller, similar to the mass flow controller comprising carrier flow sensor 116 and carrier flow valve 118. Reactant flow sensor 114 measures the mass flow of the reactant gas in combination with the carrier gas, which combination proceeds into reaction chamber 102. Components downstream of ampule 134 are maintained 15-20 ° C higher than liquid source 136, which is usually maintained at 30-40 ° C to avoid condensation and to avoid drift of carrier flow sensor 116 and reactant flow sensor 114. The combined gas measured by reactant flow sensor continues its flow into reaction chamber 102.

The TEOS is reacted with $O_2$ in a thermal process to cause deposition of a silicon dioxide layer on wafer 99. Heat for the deposition reaction is provided by heat source 106, which provides ultra-violet radiation for "cold-wall" heating wafer 99. Alternatively, radio frequency energy, visible light or infra-red radiation can be used for cold-wall heating or thermal-resistance heating can be used for hot-wall heating. The deposition reaction can be plasma enhanced, or ozone can be used instead of $O_2$ in the the thermal reaction. The ozone, oxygen or any other co-reactant can be introduced using a co-reactant gas delivery section, which can be closed loop in the manner of gas delivery section 104. However, if the mass flow rate of the co-reactant is not critical, the co-reactant delivery section can be open loop.

Carrier gas and gaseous by-products of the deposition reaction are pumped into effluent handling section 108 by pump 122 for proper treatment and disposal. Pump 122 is a variable delivery pump which is controlled by controller 110 as a function of reaction chamber pressures as measured by pressure sensor 120 to maintain a constant chamber pressure.

CVD system 100 is described above from the perspective of gas handling. A control perspective identifies several control loops in which system components communicate with controller 110 via a control bus CB. The gas delivery loop involves the adjustment of carrier flow valve 118 via control line 156 as a function of carrier flow measurements received from carrier flow sensor 116 along data line 158 and combined gas flow measurements received from reactant flow sensor 114 along data line 160. The effluent handling loop regulates the pressure within reaction chamber 102 by controlling exhaust pump 122 via control line 162 as a function of pressure readings received from pressure sensor 120 along data line 164.

A reaction temperature loop is implemented by controlling heat source 106 via control line 166 as a function of chamber temperature data received from a thermal sensor 168 via a data line 170. The temperature of liquid source 136 is regulated by adjusting ampule heater 150 via control line 172 in response to data received along a data line 174 from thermal sensor 148. Data received from level sensor 146 along data line 176 is used to indicate when liquid source 136 needs to be replenished, either automatically or manually. Controller 110 also communicates with system components via other control and data lines to implement control functions well understood in the art. In addition, controller 110 supplies timing signals as required to implement and coordinate the control functions.

In addition to regulating parameters during deposition, controller 110 implements a calibration mode, opening calibration valve 128 and closing ampule inlet valve 130 and ampule outlet valve 132 using control signals conveyed along calibration lines 178. Carrier flow sensor 116 and reactant flow sensor 114 should be calibrated relative to each other, since, in system 100, they belong to different models of mass flow controllers. Specifically, reactant flow sensor is associated with a mass flow controller with twice the capacity of the mass flow controller associated with carrier flow sensor 116. The reason for this larger capacity is to accommodate the combined mass flow which is typically 20%-80% greater than the carrier mass flow. Accordingly, calibration is required to ensure that the measurements taken by different sensors are comparable.

During the relative calibration mode, liquid source 136 is eliminated from the gas stream which proceeds directly from carrier flow sensor 118 to reactant flow sensor 114 via calibration valve 128. Since, in this mode, sensors 114 and 118 detect the same gas flow, they can be calibrated relative to each other by comparing their readings at a succession of different carrier flow rates. Controller 110 applies a least squares fit to the compared readings to derive a linear transformation of carrier flow readings into reactant flow readings.

Absolute calibration of the sensors can be performed using a "leak-up" test. Carrier is introduced into reaction chamber 102, or another chamber, at a constant rate, while chamber pressure is monitored. The duration required to achieve a predetermined pressure provides an accurate measure of flow rate. The flow rate so determined can be compared with reactant flow sensor readings to calibrate the latter. In system 100, the results of the relative and absolute calibrations are implemented in software as described in connection with a more detailed explanation of the gas delivery control loop below.

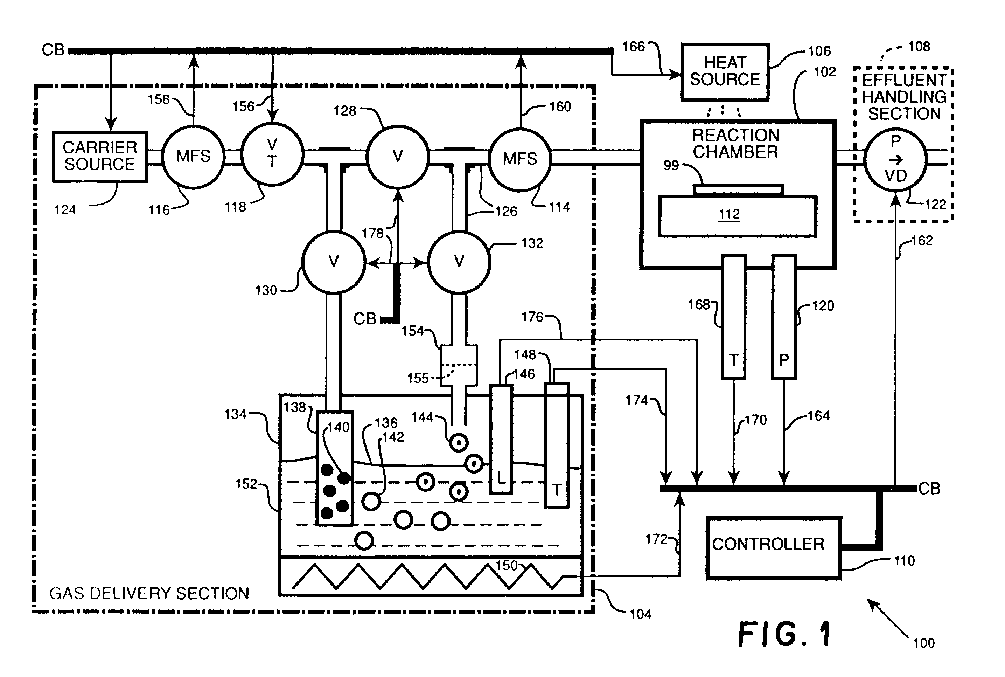

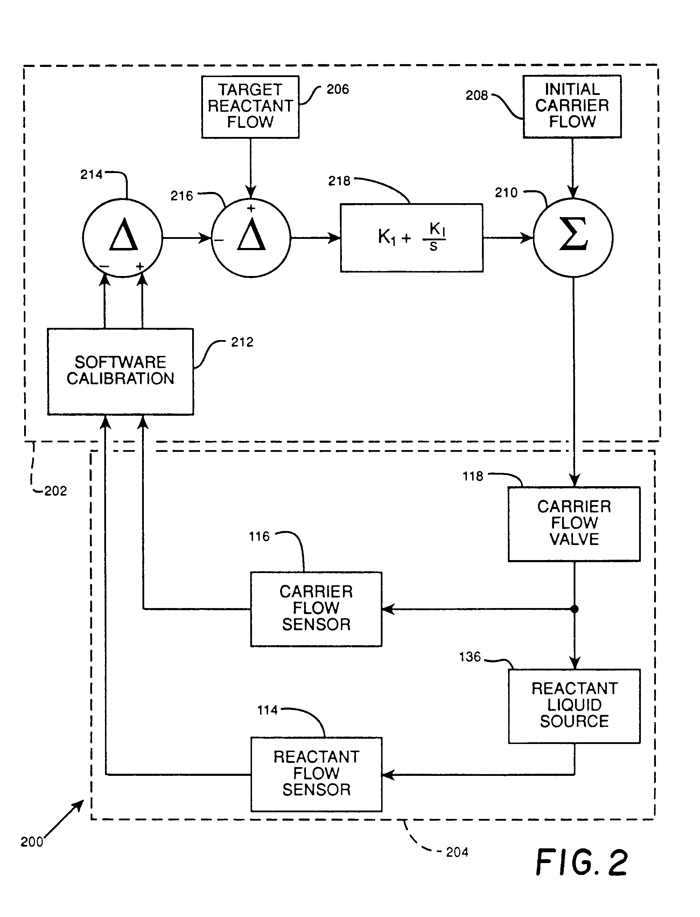

Gas delivery loop 200 includes a control portion 202 and a feedback portion 204, as shown in FIG. 2. Feedback portion 204 is associated with gas delivery section 104 of FIG. 1 and comprises actions involving carrier flow valve 118, liquid source 136, carrier flow sensor 116 and reactant flow sensor 114. Control portion 202 is associated with controller 110. A process recipe prescribes a target reactant flow value 206 to be attained and maintained by control loop 200. An initial carrier flow value 208 is calculated by controller 110 from the target reactant flow in combination with available data on factors which determine the relationship between carrier flow and reactant flow. These factors include the temperature, pressure and level associated with liquid source 136 and the pressure within reaction chamber 102. Initial carrier flow value 208 is a feed forward signal to reduce the magnitude and duration required for control loop 200 to stabilize.

Initial carrier flow value 208 is supplied through add function 210 to control carrier flow valve 118 and the mass flow of the resulting mass flow rate of carrier gas is measured by carrier flow sensor 116. The carrier gas bubbles through liquid source 136, where it acquires reactant gas. The resulting combined gas flow is measured by reactant flow sensor 114. The mass flow readings are calibrated by a software calibration function 212 of control portion 202. Conceptually, software calibration function 212 translates carrier flow readings to values that would have resulted had the same flow been measured by reactant sensor 114. In addition, calibration function 212 makes adjustments in both the reactant flow readings and the translated carrier flow readings as dictated by the leak-up portion of the calibration procedure. The calibrated flow readings are then compared by feedback comparator function 214. The result of the comparison is the "actual" value of the reactant mass flow rate.

It is noted that calibration can be performed in many different ways and that the results of a calibration process can be utilized different ways. In particularly, the feedback comparison and software calibration steps need not be sequential as indicated. For example, relative calibration can be followed by subtraction which is in turn followed by absolute calibration. Alternatively, absolute calibration can be applied to both carrier and reactant sensor readings, followed by comparison, thus dispensing with relative calibration altogether.

The actual reactant flow value is directed to a target comparison function 216. Target comparison function 216 receives this actual value and compares it to target reactant flow value 206. The difference is an error signal, which is modified by a proportional+integral function 218 as is known in the controller theory art to cause proper convergence of a control loop. The modified error value is directed to add function 210, which combines the modified error signal with the initial carrier flow value 208 to adjust the control signal applied to carrier flow valve 118, thus closing gas delivery control loop 200.

As described, the present invention controls reactant mass flow rate by adjusting the carrier flow rate. Most CVD processes are not sensitive to variations in flow rates of an inert carrier gas within a certain range. However, if required, the carrier mass flow rate at the CVD chamber can be held constant by providing an auxiliary carrier gas source which merges with the combined gas flow, bypassing the liquid source. The auxiliary gas flow is controlled to offset changes in the mass flow rate of carrier gas through the ampule to maintain a constant total carrier gas flow. Alternatively, the carrier mass flow controller can be designed to variably divide the carrier gas stream into two components, one of which is transported through the ampule and the other which merges with the combined gas flow. This guarantees a constant total carrier gas flow without requiring the coordinated regulation of two carrier gas flows.

Advantages of CVD system 100 are made apparent in connection with chemical vapor deposition of silicon dioxide where tetraethylorthosilicate (TEOS) is used as the reactant gas. As described in the background section above, there has been a problem in obtaining accurate, repeatable, and reliable control of the liquid TEOS source. Note that the gas delivery loop converges even when conditions such as reactant temperature and level or gas pressure change. Thus, temperature control is less critical than it is for an open loop bubbler. For example, in CVD system 100, an acceptable temperature tolerance would be +/-3 °C. Comparable performance in an open loop bubbler of the prior art would require temperature maintenance with less than 0.5 °C.

Since the CVD system 100 is not dependent on maintaining a constant temperature and since it is relatively tolerant of temperature variations, it can be reliably operated at higher temperatures than a comparable open loop system. Higher ampule temperatures translate into higher vapor pressures, which in turn permit higher CVD chamber pressures. Some CVD processes require chamber pressures that are not conveniently attained by prior art systems when a low vapor pressure material like TEOS is used for the reactant. As a result, some favorable processes cannot be used and others must be compromised to accept lower than optimal pressures. CVD system 100 permits much higher chamber pressures, which allows greater selection and greater optimization of deposition procedures. By way of example, an exemplary plasma CVD system attains 5-15 torr*chamber pressures, and an exemplary thermal CVD system attains 30-100 torr*chamber pressures, whereby the CVD system can exceed 760 torr* chamber pressures.

* 1 torr = 1 mm Hg = 1.333 mbar

As indicated above, reactant flow sensor 114, carrier flow sensor 116, and carrier flow valve 118 are components of commercially available mass flow controllers. Mass flow controllers precisely measure, monitor and control the mass flow of gases in processes such as plasma etching, diffusion, sputtering, as well as epitaxial and other chemical vapor deposition processes. A typical mass flow controller includes a sensor tube in parallel with a by-pass tube through which the bulk of the through-going gas flows. Wound around the sensor tube are two identical wire wound sensor resistors that, in the absence of flow generate a symmetrical temperature profile along the sensor tube. When gas flows through the MFC, a restriction in the by-pass tube causes a percentage of the flow to take the path provided by the sensor tube. Heat carried away from the gas flowing through the sensor tube carries away heat generated by the sensor resistors. This causes the temperature profile along the sensor tube to change, and the two resistor's temperatures become different. The two sensors are part of a wheatstone bridge circuit which is heated with a constant current source. The mass flow of the gas determines the extent to which the temperatures changes, and hence the amount the resistances of the windings change. The resistance changes result in voltage changes which can be readily measured. Typically, a mass flow sensor must be calibrated for the gas being monitored. The calibration is a function, at least in part, of the molecular mass and the specific heat of the monitored gas. Further information on mass flow controllers is availabe from various sources, for example, owners manuals for mass flow controllers are available from Unit Instruments, Inc., Orange, California.

The present invention provides for a wide variety of process materials, temperatures and pressures can be accommodated. Different materials can be deposited, such as epitaxial and polycrystalline silicon, and silicon nitride. Silicon dioxide, both doped and undoped, can be deposited using reactants other than TEOS. In addition, non-silicon based processes can be accommodated by the present invention. As indicated, there are a broad range of calibration procedures and methods for applying calibration results. For example, the sensor hardware itself can be calibrated or various software calibration techniques can be used. In the illustrated embodiment, a heater element is used in regulating the temperature of the liquid source; in some cases a cooling element or a combination heating/cooling element is preferred. These and other variations upon and modifications to the described embodiments are provided for by the present invention defined through the appended claims.

**Claims**

1. A chemical vapor deposition system (100) comprising:

a chamber (102) for reacting reactant gas for forming a deposition on a substrate (99) contained by said chamber (102),

pressure sensor means (120) for sensing the pressure within said chamber (102),

a heat source (106) for providing heat to said chamber (102) for facilitating said reacting,

an effluent handling section (108) with a variable delivery exhaust pump (122) for evacuating gas from said chamber (102) at an adjustable evacuation rate, to maintain the interior of said chamber at substantially constant pressure,

gas delivery means (104) for delivering reactant gas to said chamber (102) at a predetermined mass flow rate, said gas delivery means (104) including

(a) a reactant gas source (134) for supplying reactant gas,

(b) a carrier gas source (124) for supplying a carrier gas,

(c) carrier conduit means for transporting said carrier gas to and through said reactant gas source (134) so as to transport said carrier gas from said reactant gas source (134) at a rate correlated with the mass flow rate of said carrier gas, said carrier gas mixing with said reactant gas to form a combined gas, said carrier gas having a carrier mass flow rate through said carrier conduit means,

(d) reactant conduit means (126) for transporting said combined gas to said chamber (102), said reactant gas having a reactant mass flow rate through said reactant conduit means (126), said combined gas having a combined mass flow rate through said reactant conduit means,

(e) carrier valve means (118) for adjusting said carrier mass flow rate,

(f) carrier sensor means (116) for providing a carrier measurement of said carrier mass flow rate,

(g) reactant sensor means (114) for providing a combined measurement of said combined mass flow rate, and

controller means (110) for coordinating the operation of the above components, said controller means (110) being coupled to said pressure sensor means (120) for monitoring the pressure within said chamber, said controller means (110) being coupled to said variable delivery exhaust pump (108) for controlling said evacuation rate so that the pressure in said chamber is held substantially constant, said controller means (110) being coupled to said carrier sensor means (116) for receiving said carrier measurements and coupled to said reactant sensor means (114) for receiving said combined measurements, said controller means (110) being coupled to said carrier valve means (118) for adjusting said carrier mass flow rate as a function of said combined and carrier measurements so that said predetermined reactant gas mass flow rate is attained and maintained.

2. A reactant delivery system, for use in a chemical vapor deposition system (100) which contains a chamber (102) having an interior maintained at substantially constant pressure, said chamber being provided with pressure sensor means (120) comprising:

a reactant gas source (134) for producing reactant gas upon vaporization and a carrier gas source (124) for supplying carrier gas,

carrier conduit means for transporting said carrier gas to and through said reactant gas source (134) so that said carrier gas mixes with said reactant gas to constitute a combined gas, said carrier gas having a carrier mass flow rate through said carrier conduit means,

reactant conduit means (126) for transporting said combined gas to said chamber (102), by effluent handling section (108) with a variable delivery exhaust pump (122), said reactant gas having a reactant mass flow rate through said reactant conduit means, said combined gas having a combined mass flow rate through said reactant conduit means,

carrier rate means (118) for adjusting said carrier mass flow rate, reactant sensor means (114) for providing combined measurements of said combined mass flow rate,

carrier sensor means (116) for providing carrier measurements of said carrier mass flow rate,

controller means (110) for regulating said reactant mass flow rate, said controller means (110) being coupled to said reactant sensor means (114) for receiving said combined measurements, said controller means (110) being coupled to said carrier sensor (116) for receiving said carrier measurements, said controller means (110) being coupled to said carrier rate means (118), for adjusting the same as a function of said carrier and combined measurements so that said reactant mass flow rate is maintained at a predetermined level.

3. The reactant delivery system of claim 2, wherein said carrier rate means includes a carrier flow valve (118) for adjusting said carrier mass flow rate so as to regulate the mass flow rate of said reactant gas.

4. The reactant delivery system of claims 2 or 3 wherein said reactant gas source (134) includes a liquid phase (136) which vaporizes to yield said reactant gas.

**Patentansprüche**

1. Vorrichtung (100) für eine Gasphasenabscheidung nach einem chemischen Verfahren, mit:

einer Kammer (102) zum Umsetzen eines Reaktandengases zum Ausbilden eines Niederschlags auf einem in der Kammer (102) enthaltenen Substrat (99),

einem Drucksensormittel (120) zum Erfassen des Drucks in der Kammer (102),

einer Wärmequelle (106) zum Versorgen der Kammer (102) mit Wärme, um die Umsetzung zu erleichtern,

einem Abgasbehandlungsabschnitt (108) mit einer Absaugpumpe (122) mit veränderbarer Förderleistung zum Evakuieren von Gas aus der Kammer (102) mit einer einstellbaren Evakuiergeschwindigkeit, um das Innere der Kammer auf einem im wesentlichen konstanten Druck zu halten,

einem Gaszuführmittel (104) zum Zuführen von Reaktandengas mit einem vorgegebenen Mengendurchfluß zur Kammer (102), wobei das Gaszuführmittel (104) umfaßt:

(a) eine Reaktandengasquelle (134) für die Versorgung mit Reaktandengas,

(b) eine Trägergasquelle (124) für die Versorgung mit einem Trägergas,

(c) ein Trägerleitungsmittel zum Transportieren des Trägergases zur und durch die Reaktandengasquelle (134), um das Trägergas von der Reaktandengasquelle (134) mit einer Geschwindigkeit, die dem Mengendurchfluß des Trägergases entspricht, zu transportieren, wobei sich das Trägergas mit dem Reaktandengas vermischt, um ein kombiniertes Gas zu bilden, wobei das Trägergas einen Trägermengendurchfluß durch das Trägerleitungsmittel aufweist,

(d) ein Reaktandenleitungsmittel (126) zum Transportieren des kombinierten Gases zur Kammer (102), wobei das Reaktandengas einen Reaktandenmengendurchfluß durch das Reaktandenleitungsmittel (126) aufweist, wobei das kombinierte Gas einen kombinierten Mengendurchfluß durch das Reaktandenleitungsmittel aufweist,

(e) ein Trägerventilmittel (118) zum Einstellen des Trägermengendurchflusses,

(f) ein Trägersensormittel (116), um eine Trägermessung des Trägermengendurchflusses zur Verfügung zu stellen,

(g) ein Reaktandensensormittel (114), um eine gemeinsame Messung des kombinierten Mengendurchflusses zur Verfügung zu stellen, und

ein Steuermittel (110) zum Koordinieren des Betriebs der oben genannten Komponenten, wobei das Steuermittel (110) zum Überwachen des Drucks in der Kammer an das Drucksensormittel (120) gekoppelt ist, wobei das Steuermittel (110) zum Steuern der Evakuiergeschwindigkeit an die Absaugpumpe (122) mit veränderbarer Förderleistung gekoppelt ist, so daß der Druck in der Kammer im wesentlichen konstant gehalten wird, wobei das Steuermittel (110) zum Empfangen der Trägermessungen an das Trägersensormittel (116) gekoppelt und zum Empfangen der gemeinsamen Messungen an das Reaktandensensormittel (114) gekoppelt ist, wobei das Steuermittel (110) zum Einstellen des Trägermengendurchflusses als Funktion der gemeinsamen Messung und der Trägermessung an das Trägerventilmittel (118) gekoppelt ist, so daß der vorgegebene Reaktandengasmengendurchfluß erreicht und aufrechterhalten wird.

2. Reaktandenzuführsystem zur Verwendung in einer Vorrichtung (100) für eine Gasphasenabscheidung nach einem chemischen Verfahren, welche eine Kammer (102) enthält, die ein Inneres aufweist, welches auf einem im wesentlichen konstanten Druck gehalten wird, wobei die Kammer mit einem Drucksensormittel (120) ausgestattet ist, mit:

einer Reaktandengasquelle (134) für die Erzeugung eines Reaktandengases nach Verdampfung und einer Trägergasquelle (124) für die Versorgung mit Trägergas,

einem Trägerleitungsmittel zum Transportieren des Trägergases zur und durch die Reaktandengasquelle (134), so daß sich das Trägergas mit dem Reaktandengas vermischt, um ein kombiniertes Gas zu bilden, wobei das Trägergas einen Trägermengendurchfluß durch die Trägerleitungsmittel aufweist,

Reaktandenleitungsmitteln (126) zum Transportieren des kombinierten Gases zur Kammer (102) über den Abgasbehandlungsabschnitt (108) mit einer Absaugpumpe (122) mit veränderbarer Förderleistung, wobei das Reaktandengas einen Reaktandenmengendurchfluß durch das Reaktandenleitungsmittel aufweist, wobei das kombinierte Gas einen kombinierten Mengendurchfluß durch das Reaktandenleitungsmittel aufweist,

einem Trägerdurchflußmittel (118) zum Einstellen des Trägerdurchflusses, ein Reaktandensensormittel (114), um gemeinsame Messungen des kombinierten Mengendurchflusses zur Verfügung zu stellen,

einem Trägersensormittel (116), um Trägermessungen des Trägermengendurchflusses zur Verfügung zu stellen,

einem Steuermittel (110) zum Regeln des Reaktandenmengendurchflusses, wobei das Steuermittel (110) zum Empfangen der gemeinsamen Messungen an das Reaktandensensormittel (114) gekoppelt ist, wobei das Steuermittel (110) zum Empfangen der Trägermessungen an das Trägersensormittel (116) gekoppelt ist, wobei das Steuermittel (110) an das Trägerdurchflußmittel (118) zum Einstellen desselben als Funktion der Trägermessungen und der gemeinsamen Messungen gekoppelt ist, so daß der Reaktandenmengendurchfluß auf einem vorgegebenen Niveau gehalten wird.

3. Reaktandenzuführsystem nach Anspruch 2, wobei das Trägerdurchflußmittel ein Trägerdurchflußventil (118) zum Einstellen des Trägermengendurchflusses umfaßt, um den Mengendurchfluß des Reaktandengases zu regeln.

4. Reaktandenzuführsystem nach Anspruch 2 oder 3, wobei die Reaktandengasquelle (134) eine flüssige Phase (136) umfaßt, welche verdampft, um das Reaktandengas zu ergeben.

**Revendications**

1. Système de dépôt chimique en phase vapeur (100) comprenant :

une chambre (102) pour faire réagir un gaz réactif et former un dépôt sur un substrat (99) contenu dans ladite chambre (102),

des moyens détecteurs de pression (120) pour détecter la pression à l'intérieur de ladite chambre (102),

une source de chaleur (106) pour fournir de la chaleur à ladite chambre (102) et faciliter ladite réaction,

une section de traitement d'effluents (108) ayant une pompe aspirante à débit variable (122) pour évacuer le gaz depuis ladite chambre (102) selon un débit d'évacuation réglable, et maintenir l'intérieur de ladite chambre à une pression sensiblement constante,

des moyens de distribution de gaz (104) pour fournir le gaz réactif à ladite chambre (102) selon un débit d'écoulement de masse prédéterminé, lesdits moyens de distribution de gaz (104) comprenant :

(a) une source de gaz réactif (134) pour fournir le gaz réactif,

(b) une source de gaz vecteur (124) pour fournir un gaz vecteur,

(c) des moyens formant conduit de gaz vecteur pour transporter ledit gaz vecteur jusque et à travers ladite source de gaz réactif (134) de façon à transporter ledit gaz vecteur depuis ladite source de gaz réactif (134) à un débit en corrélation avec le débit de masse dudit gaz vecteur, ledit gaz vecteur se mélangeant avec ledit gaz réactif pour former un gaz combiné, ledit gaz vecteur ayant un débit d'écoulement de masse de gaz vecteur au travers dudit moyen formant conduit de gaz vecteur,

(d) un moyen formant conduit de gaz réactif (126) pour transporter lesdits gaz combinés vers ladite chambre (102), ledit gaz réactif ayant un débit d'écoulement de masse de gaz réactif au travers dudit moyen formant conduit de gaz réactif (126), lesdits gaz combinés ayant un débit d'écoulement de masse de gaz combinés au travers dudit moyen formant conduit de gaz réactif,

(e) des moyens formant vanne de gaz vecteur (118) pour régler ledit débit d'écoulement de masse de gaz vecteur,

(f) des moyens de détection de gaz vecteur (116) pour fournir une mesure dudit débit d'écoulement de la masse de gaz vecteur,

(g) des moyens de détection du gaz réactif (114) pour fournir une mesure dudit débit d'écoulement de masse de gaz combinés, et

des moyens de commande (110) pour coordonner le fonctionnement des composants indiqués ci-dessus, lesdits moyens de commande (110) étant accouplés auxdits moyens détecteurs de pression (120) pour contrôler la pression à l'intérieur de ladite chambre, lesdits moyens de commande (110) étant accouplés à ladite pompe d'aspiration à débit variable (122) pour commander ledit débit d'évacuation, de telle sorte que la pression dans ladite chambre soit maintenue sensiblement constante, lesdits moyens de commande (110) étant accouplés auxdits moyens détecteurs de gaz vecteur (116) pour recevoir les mesures de gaz vecteur et accouplés auxdits moyens détecteurs de gaz réactif (114) pour recevoir lesdites mesures de gaz combinés, lesdits moyens de commande (110) étant accouplés auxdits moyens formant vanne de gaz vecteur (118) pour régler ledit débit d'écoulement de masse de gaz vecteur en fonction desdites mesures de gaz vecteur et de gaz combinés, de telle sorte que ledit débit d'écoulement de masse de gaz réactif prédéterminé soit atteint et maintenu.

2. Système de distribution de réactif pour l'utilisation dans un système de dépôt chimique en phase vapeur (100) qui comprend un chambre (102), dont l'intérieur est maintenu à une pression sensiblement constante, ladite chambre étant pourvue de moyens détecteurs de pression (120) comprenant :

une source de gaz réactif (134) pour produire un gaz réactif par vaporisation et une source de gaz vecteur (124) pour fournir un gaz vecteur,

des moyens formant conduit de gaz vecteur pour transporter ledit gaz vecteur jusqu'à et à travers ladite source de gaz réactif (134), de telle sorte que le gaz vecteur se mélange avec ledit gaz réactif pour constituer un gaz combiné, ledit gaz vecteur ayant un débit d'écoulement de masse de gaz vecteur au travers desdits moyens formant conduit de gaz vecteur,

des moyens formant conduit de gaz réactif (126) pour transporter ledit gaz combiné vers ladite chambre (102), par une section de traitement d'effluents (108) ayant une pompe aspirante (122) à débit variable, ledit gaz réactif ayant un débit d'écoulement de masse de gaz réactif au travers dudit moyen formant conduit de gaz réactif, ledit gaz combiné ayant un débit d'écoulement de masse de gaz combinés au travers dudit moyen formant conduit de gaz réactif,

des moyens de réglage de débit de gaz vecteur (118) pour régler ledit débit d'écoulement de masse du gaz vecteur, des moyens détecteurs de gaz réactif (114) pour fournir des mesures dudit débit d'écoulement de masse de gaz combinés, des moyens détecteurs de gaz vecteur (116) pour fournir des mesures dudit débit d'écoulement de masse de gaz vecteur,

des moyens de commande (110) pour réguler ledit débit d'écoulement de masse de gaz réactif, lesdits moyens de commande (110) étant accouplés auxdits moyens détecteurs de gaz réactif (114) pour recevoir lesdites mesures combinées, lesdits moyens de commande (110) étant accouplés auxdits moyens détecteurs de gaz vecteur (116) pour recevoir lesdites mesures de gaz vecteur, lesdits moyens de commande (110) étant accouplés auxdits moyens de réglage de débit de gaz vecteur (118) pour régler ceux-ci en fonction desdites mesures de gaz vecteur et de gaz combinés, de telle sorte que le débit d'écoulement de masse de gaz réactif est maintenu à un niveau prédéterminé.

3. Système de distribution de réactif selon la revendication 2, dans lequel ledit moyen de réglage de débit de gaz vecteur comprend une vanne d'écoulement de gaz vecteur (118) pour régler ledit débit d'écoulement de masse de gaz vecteur, de façon à réguler le débit d'écoulement de masse dudit gaz réactif.

4. Système de distribution de réactif selon la revendication 2 ou 3, dans lequel ladite source de gaz réactif (134) comprend une phase liquide (136) qui est vaporisée pour donner ledit gaz réactif.

FIG. 1

EP 0 370 311 B1

12

FIG. 2